Europäisches Patentamt

European Patent Office

Office européen des brevets

(11) Publication number: **0 516 142 A2**

# EUROPEAN PATENT APPLICATION

(21) Application number: **92109086.6**

(22) Date of filing: **29.05.92**

(51) Int. Cl.5: **H01L 21/311**

(30) Priority: **31.05.91 US 708604**

(43) Date of publication of application:
**02.12.92 Bulletin 92/49**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Douglas, Monte A.**
**627 Hood Drive**
**Coppell, Texas 75019(US)**

(74) Representative: **Schwepfinger, Karl-Heinz, Dipl.-Ing. et al**
**Prinz, Leiser, Bunke & Partner Manzingerweg 7**
**W-8000 München 60(DE)**

(54) **Photo-stimulated etching of CaF2.**

(57) Generally, and in one form of the invention, a method is presented for the photo-stimulated etching of a $CaF_2$ surface 12, comprising the steps of exposing the $CaF_2$ surface 12 to an ambient species 16, exciting the $CaF_2$ surface 12 and/or the ambient species 16 by photo-stimulation sufficiently to allow reaction of the $CaF_2$ surface 12 with the ambient species 16 to form $CaF_2$/ambient species products, and removing the ambient species 16 and the $CaF_2$/ambient species products from the $CaF_2$ surface 12.

Other devices, systems and methods are also disclosed.

FIG 2

## FIELD OF THE INVENTION

This invention generally relates to methods for etching $CaF_2$.

## BACKGROUND OF THE INVENTION

Without limiting the scope of the invention, its background is described in connection with the etching of $CaF_2$ epitaxial layers for any suitable devices.

To date, however no acceptable method of etching $CaF_2$ has yet been developed. There are three methods at present to etch $CaF_2$: water, dilute nitric acid ($HNO_3$) and dry etching with various energy sources. The water etch is very slow (the solubility of $CaF_2$ in water is quite low - 0.002 grams in 100 grams of water at 25 C) as well as unreliable - it is difficult to determine when etching begins, when it finishes, or even when it is ongoing. Additionally, when water is used to etch $CaF_2$, it cracks the $CaF_2$ film, creating "ice floe" regions, and ruining the sample. The nitric acid approach is not much better than water. Undiluted, it will not etch $CaF_2$. Too much dilution results in the same outcome observed with the water etch, presumably associated with the higher water content. A 3:1 or 2:1 water:nitric acid dilution etches $CaF_2$ very rapidly - 2-3 seconds for a 1000 - 2000 Angstrom film. However, the reproducibility of this etch is very poor, the etch rate cannot be consistently reproduced in large volume production. Moreover, severe undercut of the film is a significant problem with a rapid, isotropic wet etch. This is particularly important in the use of $CaF_2$ in nanometer scale devices

A dry etch method driven by any of a variety of energy sources such as RF, microwave, ECR, etc. would introduce severe damage into the delicate $CaF_2$ crystalline structure, destroying any possibility of forming nanometer scale devices

A typical problem experienced with the above methods is that the $CaF_2$ will resist etching for a period of time and then start to etch along preferred regions very rapidly, causing the $CaF_2$ to lift off in flakes. This results in a residual surface that is well textured. Two types of texturing are most prevalent with the prior art etch methods: undulations on the surface reflective of thickness variations and cracking of the film. Undulation-type texturing is a disaster, since small variations in the epitaxial film thickness cause large changes in the material/device behaviour which are peculiar to, for example, resonant tunnelling components. Cracking of the film is equally unacceptable, since leakage through the film destroys any type of device performance. Also, resistivity is an important parameter of the material that must be carefully controlled - a crack in the film would undermine the fabricated value. Accordingly, improvements which overcome any or all of these problems are presently desirable.

## SUMMARY OF THE INVENTION

It is herein recognized that a need exists for a method to etch $CaF_2$ which overcomes any or all of the problems discussed above. The present invention is directed towards meeting those needs.

Generally, and in one form of the invention, a method is presented for the photo-stimulated etching of a $CaF_2$ surface, comprising the steps of exposing the $CaF_2$ surface to an ambient species, exciting the $CaF_2$ surface and/or the ambient species by photo-stimulation sufficiently to allow reaction of the $CaF_2$ surface with the ambient species to form $CaF_2$/ambient species products, and removing the ambient species and the $CaF_2$/ambient species products from the $CaF_2$ surface.

In another form of the invention, a method is presented for the photo-stimulated etching of a $CaF_2$ surface, comprising the steps of placing the $CaF_2$ surface into a vacuum environment, lowering the temperature of the $CaF_2$ surface to the dew point, introducing water vapor into the vacuum environment, irradiating the $CaF_2$ surface and any condensed water with visible and/or ultraviolet light and returning the environment to a vacuum.

An advantage of the invention is that it allows for the etching of $CaF_2$ in a controlled manner without the texturing problems produced by prior art methods.

## BRIEF DESCRIPTION OF THE DRAWINGS

The foregoing and further aspects of the invention are illustrated in the accompanying drawings wherein like elements are denoted by like reference designators and in which:

FIG. 1 is a diagram of suitable apparatus for performing the first preferred embodiment method; and
FIG. 2 is a diagram of suitable apparatus for performing the second preferred embodiment method.

## DETAILED DESCRIPTION OF PREFERRED EMBODIMENTS

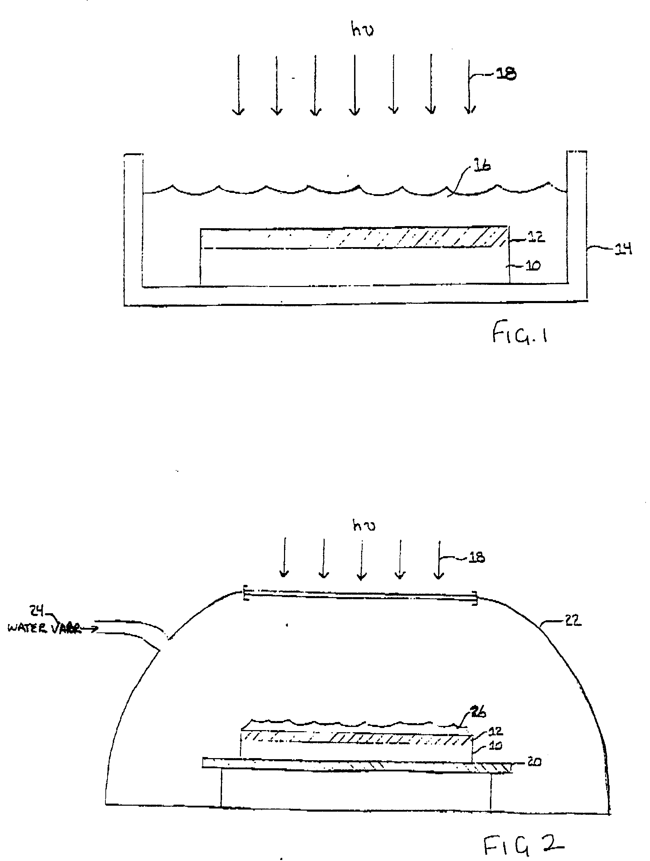

A first preferred embodiment method of the present invention can be used to achieve smooth, continuous etching of $CaF_2$. With reference to Figure 1, a silicon substrate 10, having an epitaxial layer 12 of $CaF_2$, is placed into a beaker 14. The beaker is then filled with water 16 so as to cover the surface of the $CaF_2$ layer 12. The $CaF_2$ layer 12 is then irradiated with optical energy 18 from, for example, a 200 Watt Hg/Xe arc lamp.

Table I shows analytical data taken from X-ray Photoelectron Spectroscopy (XPS) of a Si substrate sample with a 2000 Angstrom $CaF_2$ film epitaxially deposited on its surface. XPS is a surface sensitive analytical method and shows the surface to be predominately $CaF_2$ (with some surface impurities). It is important to note that the XPS measurement of this sample shows no indication of Si.

Table I

| Before Etch | | |
|---|---|---|
| Element | Atomic % | Possible Compound |
| F | 55.9 | F in $CaF_2$ |
| Ca | 24.7 | Ca in $CaF_2$ |
| C | 13.7 | graphite, hydrocarbon |
| O | 5.6 | organic |
| Mg | 0.2 | Mg in $MgF_2$ |

Table II lists the results of an XPS analysis on the same sample after a photo-stimulated etch using the first preferred embodiment method of the present invention. The $CaF_2$ on the sample surface has decreased to 22.3% and there is a relatively large presence of Si, indicating that the $CaF_2$ has been etched completely down to the Si substrate beneath. For this trial, a visual endpoint was used to stop the etch, i.e. a 2000 Angstrom layer of $CaF_2$ appears blue (due to diffraction) and the etch was stopped after it was observed that the blue coloration of the sample disappeared. The XPS analysis indicates that the etch should have been allowed to proceed longer since some of the $CaF_2$ remained after the etch.

Table II

| After Etch | | |
|---|---|---|
| Element | Atomic % | Possible Compound |
| O | 37.3 | organic, moisture |
| F | 15.1 | F in $CaF_2$ |
| C | 13.5 | graphite, hydrocarbon |
| Si | 13.0 | elemental Si |
| Si | 11.9 | silicate |
| Ca | 7.2 | Ca in $CaF_2$ |
| Na | 0.9 | $Na(O_x)$ |
| C | 0.7 | ether |
| Mg | 0.3 | Mg in $MgF_2$ |

An important point to note about the present invention is that the etch is preferential to $CaF_2$ and does not etch the Si substrate beneath. In fact, there is some evidence to suggest that the photo-stimulated of Si in a water ambient produces a very thin layer of $SiO_2$ on the substrate surface, which can be beneficial in "sealing" the surface during transport to the next wafer processing operation.

The sample wafers of Table I and II were also analyzed using X-ray Fluorescence Spectroscopy (XRF), which is a bulk concentration analytical technique. The results of the XRF analysis, listed in Table III, show that the photo-stimulated etch removed 95% of the $CaF_2$ from the etched wafer as compared to the unetched control wafer.

Table III

| Bulk Analysis | | |
|---|---|---|
| Measurement | Ca($\mu$g/cm$^2$) | Ca (atoms/cm$^2$) |
| Before Etch | 17.2 | $2.58 \times 10^{17}$ |
| After Etch (center) | 0.924 | $1.39 \times 10^{16}$ |
| After Etch (edge) | 0.884 | $1.33 \times 10^{16}$ |

The first preferred embodiment of the present invention may optionally be modified in several ways. For example, the water 16 may be ultrasonically or megasonically agitated to provide a mechanical aid to the removal of the reaction products from the substate 10 surface. Also, rather than immersing the wafer 10 into a stagnant water 16 reservoir, it may be placed into a flowing or spraying water atmosphere. The moving water would ensure that solubility limits (which would limit removal by dissolution into the water) would not be achieved.

Although the chemistry of photo-stimulated etching of $CaF_2$ is not completely understood at the present time, it is believed that a possible mechanism for the reaction may involve electronic excitation of a ground-state, $CaF_2$-ambient species adduct precursor. The $CaF_2$-ambient species adduct precursor that is excited may be the $CaF_2$ surface itself, or the ambient species (e.g. a water molecule in the first preferred embodiment), or a complex that is formed between the two entities (see formulae I-III, below). The excitation may be electronic excitation, vibrational excitation, dissociative excitation, etc., for example. The lifetime of the excitation is sufficient to allow reaction of the $CaF_2$-ambient species adduct to a $CaF_2$ product to proceed along an excited state reaction co-ordinate that is not encumbered by energy barriers that undermine reaction along the ground-state potential energy (PE) surface. Both the $CaF_2$ and the ambient species may need to be excited at the same time. The resultant product, which contains the material to be etched, may then be removed form the surface of the wafer 10 along with the ambient species, or the product may diffuse into the ambient species and therefore be removed when the ambient species is removed. Whatever the mechanism may be, the $CaF_2$ on the surface is etched and can be removed.

Following are schematic representations of three possible reactions which would form a $CaF_2$-ambient species reaction product which is soluble:

I  $CaF_2 + h\underline{\quad} \longrightarrow CaF_2{}^*$
$CaF_2{}^* + AS \longrightarrow CaF_2/AS^*$ or $CaF_2/AS$
(which is soluble)

II  $AS + h\underline{\quad} \rightarrow AS^*$
$AS^* + CaF_2 \rightarrow CaF_2/AS^*$ or $CaF_2/AS$
(which is soluble)

III  $CaF_2{-}AS + h\underline{\quad} \rightarrow CaF_2/AS^*$ or $CaF_2/AS$
(which is soluble)

where
  $CaF_2$       = $CaF_2$ surface
  $CaF_2{}^*$       = energetically excited $CaF_2$ surface
  AS         = ambient species
  $AS^*$        = energetically excited ambient species
  $CaF_2/AS$     = reaction product between $CaF_2$ & AS
  $CaF_2/AS^*$     = energetically excited reaction product
  $CaF_2{-}AS$     = $CaF_2$ weakly bound to AS
moreover:

AS = P or D

where:

P = parent reactant

D = daughter reactant

and D is created spontaneously, is in equilibrium or is generated by photo-stimulation: P + h__ = D.

It is important to note that the photo-stimulated etching of $CaF_2$ is a directional etch process. Because the reaction is catalysed to a large extent by photo-exposure, areas not exposed to photo-stimulated, such as those areas under a photoresist mask, will not etch. This directionality of etch is a major improvement over conventional wet etches which undercut the mask, making sharply delineated or very small structures difficult, if not impossible, to define. Another benefit of the photo-stimulated etching is that in some cases the photoresist mask may be eliminated all together. In this case the photo-stimulation may be applied as a patterned exposure, etching the $CaF_2$ surface only where the photo-energy is directed and not etching the $CaF_2$ surface in the non-stimulated areas. For large surfaces, a step-and-repeat exposure method may be employed.

Figure 2 illustrates a suitable apparatus setup to implement a second preferred embodiment method of the present invention. A silicon substrate 10, having an epitaxial layer 12 of $CaF_2$, is placed onto a temperature controlled chuck 20. The substrate 10/chuck 20 is then placed into a vacuum chamber 22 which is then evacuated. Next, the temperature of the chuck 20 (and hence the substrate 10/epilayer 12) is lowered to the dew point or below it, after which water vapor 24 is introduced into the chamber 22. After a period of time, a thin layer of condensed water 26 will form preferentially on the $CaF_2$ 12 surface due to its temperature being at or below the dew point. Then, the substrate 10/water 26 is irradiated with photo-energy 18 from, for example, a 200 Watt, high pressure, Hg/Xe arc lamp for five minutes. Finally, the chamber 22 is evacuated, removing all of the water vapor 24, condensed water 26 and etched $CaF_2$. Optionally, the substrate can be rinsed with water for five seconds, for example and then dried with nitrogen gas to remove $CaF_2$ reaction products.

The second preferred embodiment method may be modified in several ways. For example, instead of using a light source to excite the $CaF_2$ and/or ambient species, other energy sources such as electron flux, electromagnetic field sources (e.g. RF, microwave, etc.), or energetic ion energy prepared and delivered to the surface by various plasma techniques (e.g. electron cyclotron reators (ECR), etc.) or broad area sources of electrons or ions under high vacuum, for example. After water has condensed onto the surface, the surface may be heated above the dew point to remove all water molecules except those that have already formed adducts with the $CaF_2$ (this will provide for more efficient exposure of the adducts to photo-stimulation). Also, the vapor phase or liquid phase ambient species may be acidic or alkaline (e.g. HCl or $NH_4OH$) or one of the standard wet etch solutions (e.g. HF). It will be appreciated that most wet etch scenarios would benefit form an excitation of the $CaF_2$ surface and/or ambient species as described in the foregoing. Additionally, the water vapor introduced into the chamber may be wet or dry steam.

Preliminary analysis of silicon surfaces exposed to photo-stimulation in a water ambient show a fourfold increase of silicon oxide ($SiO_x$) at the surface after treatment (the analysis technique employed is sensitive to a depth of approximately 40 Angstroms). This provides a significant added benefit in that the surface is effectively "sealed" after $CaF_2$ etch to protect it from further contamination before the next processing step can be performed.

A few preferred embodiments have been described in detail herein above. It is to be understood that the scope of the invention also comprehends embodiments different from those described, yet within the scope of the claims.

The term photo-stimulation is used herein for convenience of description, however the term "photo" may be replaced with "radiant energy" or "energetic ion energy" throughout the specification and the appended claims.

Words of inclusion are to be interpreted as non exhaustive in considering the scope of the invention.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method for the photo-stimulated etching of a $CaF_2$ surface, comprising the steps of:
   exposing said surface to an ambient species;

exciting said surface and/or said ambient species by photo-stimulation sufficiently to allow reaction of said surface with said ambient species to form $CaF_2$/ambient species reaction products; and removing said ambient species and said reaction products from said surface.

2. The method of Claim 1 wherein said covering step comprises immersing said surface in a liquid ambient species.

3. The method of Claim 1 wherein said covering step comprises condensing a vapor phase ambient species on said surface.

4. The method of any preceding claim, wherein said ambient species is water.

5. The method of any preceding claim, wherein said excitation is provided by a Hg/Xe arc lamp.

6. The method of any preceding claim, wherein said exciting said surface step comprises projecting a patterned photo-stimulated onto said surface.

7. The method of any preceding claim, further including causing said ambient species to flow over said surface.

8. The method of any preceding claim, further including agitating said ambient species.

9. The method of any preceding claim, further comprising the step of drying said $CaF_2$ surface with nitrogen gas.

10. The method of any preceding claim, further comprising the step of rinsing said $CaF_2$ surface.

11. A method for the photo-stimulated etching of a $CaF_2$ surface, comprising the steps of:
placing said $CaF_2$ surface into a vacuum environment;
introducing a water vapor into said vacuum environment;
irradiating said $CaF_2$ surface and any water at said surface with visible and/or ultraviolet light.

12. The method of Claim 11 further comprising the step of maintaining a temperature of said $CaF_2$ surface at or below dew point.

13. The method of Claim 11 further comprising the step of maintaining a temperature of said $CaF_2$ surface above dew point.

14. The method of any of claim 11 to 13 wherein said water vapor is steam.

15. The method of any of claims 11 to 14 further comprising the step of returning said environment to a vacuum.

16. The method of any of claims 11 to 15 further comprising the step of drying said $CaF_2$ surface with nitrogen gas.

17. The method of any of claims 11 to 16 further comprising the step of rinsing said $CaF_2$ surface.

18. The method of Claim 17 further comprising the step of drying said $CaF_2$ surface with nitrogen gas.

hυ

18

16

12

10

14

FIG. 1

hυ

18

24
WATER VAPOR →

22

26

12
10

20

FIG 2